(19) **Europäisches Patentamt**

**European Patent Office**

**Office européen des brevets**

(11) **EP 1 267 213 B1**

(12) **EUROPEAN PATENT SPECIFICATION**

(45) Date of publication and mention
of the grant of the patent:
**20.09.2006 Bulletin 2006/38**

(51) Int Cl.:
***G03F 7/20*** *(2006.01)*

(21) Application number: **02254128.8**

(22) Date of filing: **13.06.2002**

(54) **Lithographic projection apparatus**

Lithographischer Projektionsapparat

Appareil de projection lithographique

(84) Designated Contracting States:
**DE FR GB IT NL**

(30) Priority: **13.06.2001 EP 01202265**

(43) Date of publication of application:
**18.12.2002 Bulletin 2002/51**

(73) Proprietor: **ASML Netherlands B.V.**
**5504 DR Veldhoven (NL)**

(72) Inventor: **Butler, Hans**
**5685 AC Best (NL)**

(74) Representative: **Leeming, John Gerard**
**J.A. Kemp & Co.,**
**14 South Square,**
**Gray's Inn**
**London WC1R 5JJ (GB)**

(56) References cited:
**EP-A- 0 632 568          EP-A- 0 762 255**
**US-A- 5 844 664          US-B1- 6 188 464**

## Description

The present invention relates to the control of drive means capable of moving object tables in a lithographic projection apparatus. More particularly, the invention relates to a lithographic projection apparatus comprising:

a radiation system for providing a projection beam of radiation;
a first object table for holding patterning means capable of patterning the projection beam according to a desired pattern;
a second object table for holding a substrate; and
a projection system for imaging the patterned beam onto a target portion of the substrate; and
drive means for generating a force so as to move one of the first and second object table during each imaging operation with respect to the projection system.

The term "patterning means" should be broadly interpreted as referring to means that can be used to endow an incoming radiation beam with a patterned cross-section, corresponding to a pattern that is to be created in a target portion of the substrate; the term "light valve" has also been used in this context. Generally, the said pattern will correspond to a particular functional layer in a device being created in the target portion, such as an integrated circuit or other device (see below). Examples of such patterning means include:

- A mask held by said first object table. The concept of a mask is well known in lithography, and its includes mask types such as binary, alternating phase-shift, and attenuated phase-shift, as well as various hybrid mask types. Placement of such a mask in the projection beam causes selective transmission (in the case of a transmissive mask) or reflection (in the case of a reflective mask) of the radiation impinging on the mask, according to the pattern on the mask. The first object table ensures that the mask can be held at a desired position in the incoming projection beam, and that it can be moved relative to the beam if so desired.
- A programmable mirror array held by a structure, which is referred to as first object table. An example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. The required matrix addressing can be performed using suitable electronic means. More information on such mirror arrays can be gleaned, for example, from United States Patents US 5,296,891 and US 5,523,193.
- A programmable LCD array held by a structure, which is referred to as first object table. An example of such a construction is given in United States Patent US 5,229,872.

For purposes of simplicity, the rest of this text may, at certain locations, specifically direct itself to examples involving a mask and a mask table; however, the general principles discussed in such instances should be seen in the broader context of the patterning means as hereabove set forth.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Twin stage lithographic apparatus are described, for example, in US 5,969,441 and WO 98/40791.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc.

Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (comprising one or more dies) on a substrate (silicon wafer) that has been coated with a layer of radiationsensitive material (resist). In general, a single substrate will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus — commonly referred to as a step-and-scan apparatus — each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. The projection beam in a scanning type of apparatus will have the form of a slit having a slit width in the scanning direction. More information with regard to lithographic devices as here described can be gleaned, for example, from US 6,046,792.

Drive means are used to move the tables in a scanning type of lithographic projection apparatus during imaging. It is very important that these drive means will work with a high precision so that both tables will move synchronously during imaging and will not cause imaging errors. Drive means that are not working with the required precise synchronization may lead to high MSD (moving standard deviation) and high MA (moving average) synchronization errors for the tables. While both tables receive the correct, exactly time-synchronous movement profiles from a set point generator, what counts is the relative position error between the substrate and the mask table:

$$e = e_{WS} - {e_{RS}}\big/{4} \qquad\qquad [1]$$

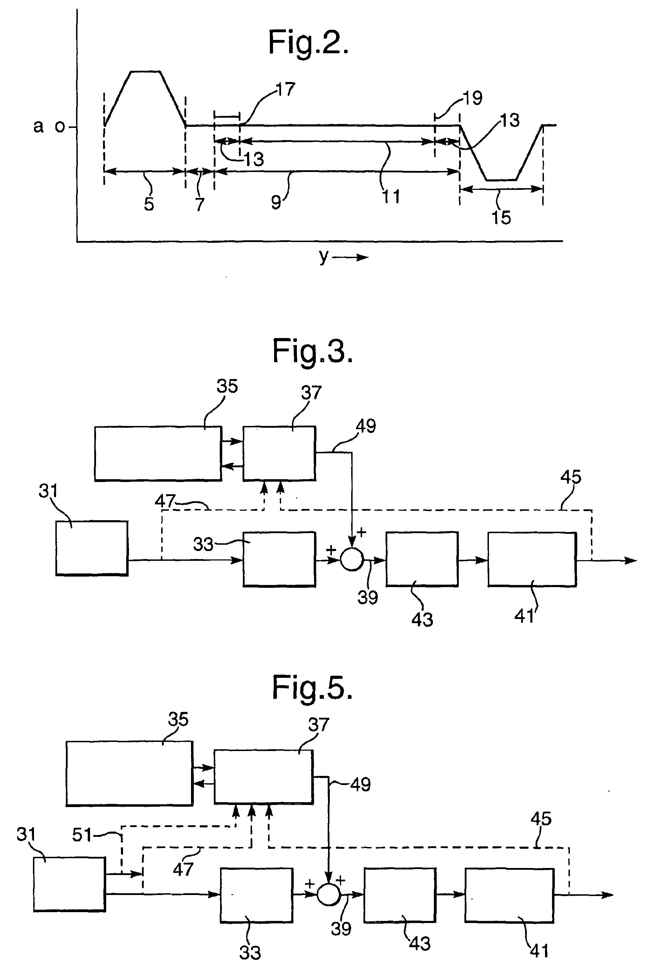

Wherein $e_{ws}$ equals the position difference between the substrate table and its set point, and $e_{RS}$ equals the position difference between the mask table and its set point. Figure 2 shows the acceleration a of the substrate table during a scan in the Y-direction. To make an exposure scan, the substrate table has to move over a distance that is equal to the target portion length 11 plus two times the slit width 13 plus the travel length 7 during the required settling time. The settling time enables the position errors to decrease. The acceleration takes place traveling the acceleration distance 5 and the deceleration takes place traveling the deceleration distance 15. At the start of the exposure 17, the first point on the target portion to be exposed reaches the illuminated slit 13. After the exposure time $T_{exp}$ this first-exposed point leaves the slit 13. After a time period that equals the target portion length divided by the stage speed, the very last point 19 of the target portion leaves the slit. Together, these amounts to the mentioned scan length 9.

The average stage position error during the time a specific point of the target portion is in the illuminated slit 13 determines the shift in the radiation sensitive material on the substrate of this specific point (overlay). For every point $x$ in the target portion, such a shift can be calculated, which is called the Moving Average (MA) error of this point $x$:

$$MA(x) = \frac{1}{T_{exp}} \int_{t_X - T_{exp}/2}^{t_X + T_{exp}/2} e(t)\,dt \qquad\qquad [2]$$

Here, $T_{exp}$ is the exposure time which equals the slit width divided by the scan speed of the substrate table, $e(t)$ is the relative substrate table / mask table position error at substrate level as function of the time, and $t_X$ is the time instant that point $x$ is positioned at the lens center.

In addition to an average position error, the position error may have highfrequency variations during exposure, resulting in fading effects (image non-sharpness or contrast loss). This effect is characterized by the Moving Standard Deviation (MSD), which equals the standard deviation of the relative position error during the exposure:

$$MSD(x) = \sqrt{\frac{1}{T_{\exp}} \int_{t_X - T_{\exp}/2}^{t_X + T_{\exp}/2} [e(t) - MA(x)]^2 \, dt} \qquad [3]$$

Both MA and MSD are calculated for every point in the target portion along the scanning direction Y. The peak MA and MSD values in the target portion are used as performance indicators.

It has been proposed in US 6,373,072 B1 to provide a control system for the substrate and mask tables of a lithographic apparatus in which errors in the position of the substrate table are compensated for by their inclusion as a feed-forward control in the mask table control loop. Specifically, the substrate table error is lowpass filtered, the output of the filter is then added to the mask table set point, and also twice differentiated, multiplied by the mask table mass and the resultant force applied to the mask table. This proposal is based on the realization that the absolute positions of the mask and substrate tables are less important than their relative position and that it is easier to control the position of the mask then the position of the substrate. The latter because any absolute error in the positioning of the mask is multiplied by the magnification of the lens system before it adds up to the imaging error at the substrate surface. The magnification of the lens will be typical 0,25 or 0,2 so that any error at the mask will be four or five times smaller at the surface of the wafer. US 5,844,664 discloses a lithographic apparatus in which a vertical compensation force is applied to a frame dependent on the position of an object table.

EP 632568 A discloses a lithographic apparatus according to the preamble of claim 1.

An object of the present invention is to provide a lithographic projection apparatus that has an improved synchronization and consequently a lower MSD and MA value.

According to the present invention there is provided a lithographic projection apparatus and a device manufacturing method as defined in the appended claims.

The drive means comprises a long-stroke and a short-stroke motor; the long-stroke motor for driving a long-range movement of said one object table and the short-stroke motor for taking care of accurate positioning of said one object table. The short-stroke motor is moved by the long-stroke motor and may be more sensitive to influences depending on the position and the velocity. The adjustment force is fed to the short-stroke motor only because this motor is in general more responsive to small force adjustments than the long-stroke motor and it may be that the long-stroke motor is just passively following the short-stroke motor. A measurement unit for measuring the relative distance between the moving part of the long-stroke motor and the part of the object table that is driven by the short-stroke motor may indicate that both are away from an equilibrium position and the long-stroke motor has to move to become in equilibrium again.

The signal representing the position of said one object table may be generated with a measurement system for measuring the position of said one object table or may be a set point generated by a controller for controlling the movement of said one object table. The data storage means will read on the basis of the signal representing the position a disturbance compensation force that will be processed in the processing means to generate a force adjustment signal for adjusting the force exerted on said one object table. The invention is based on the discovery that certain magnetic material may exert forces on the object tables during movement of the tables. The external magnetic disturbance forces may depend on either the position or the position in combination with the velocity of said one object table. Both dependencies can be determined and stored in data storage means wherefrom they can be read out to adjust the force response of the drive means in advance so as to compensate for the external magnetic disturbance forces. The position dependent external magnetic disturbance forces are caused by, e. g. attraction between permanent magnets present in the object tables and magnetic materials in the vicinity of the movement path of the object table. A step-and-scan type of apparatus each target portion is irradiated by moving the mask pattern under the projection beam in a given reference direction while synchronously moving the substrate table parallel or anti-parallel to this direction. To achieve that the mask pattern and the substrate table are moving synchronously the movement of the first and second object table must be controlled with a high accuracy. The sensitivity to errors in movement of the object table is very high, because during imaging the tables are moving and every disturbance force will directly lead to high MSD and MA values. Especially the first object table is sensitive to external magnetic disturbance forces.

At a high moving speed of said one object table there is a disturbance force present at certain positions in the moving range, which shows a speed dependency due to e.g. eddy current effects. The adjustment forces of these also velocity dependent external magnetic disturbance forces are calculated as a function of the stored disturbance compensation force as a function of the position and the speed of said one object table. Calculating means therefore multiplies the disturbance compensation force with the speed of said one object table to calculate the adjustment force.

Although specific reference may be made in this text to the use of the apparatus according to the invention in the manufacture of ICs, it should be explicitly understood that such an apparatus has many other possible applications.

For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target area" or "target portion", respectively.

In the present document, the terms illumination radiation and illumination beam are used to encompass all types of electromagnetic radiation or particle flux, including, but not limited to, ultraviolet radiation (e.g. at a wavelength of 365nm, 248 nm, 193 nm, 157nm or 126nm), EUV, X-rays, electrons and ions.

The present invention will be described below with reference to exemplary embodiments and the accompanying schematic drawings, in which:

> Figure 1 depicts a lithographic projection apparatus according to a first embodiment of the invention;
> Figure 2 shows the acceleration profile during exposure of the object tables
> Figure 3 shows a detailed flow chart of the first embodiment of the invention;
> Figure 4 shows the position dependent external magnetic disturbance forces in the Y, X and Rz direction for a first object table moving in the Y-direction;
> Figure 5 shows a detailed flow chart of a second embodiment according to the invention; and
> Figure 6 shows the velocity and position dependent external magnetic disturbance forces in the Y-direction for a first object table moving in the Y-direction.

Embodiment 1

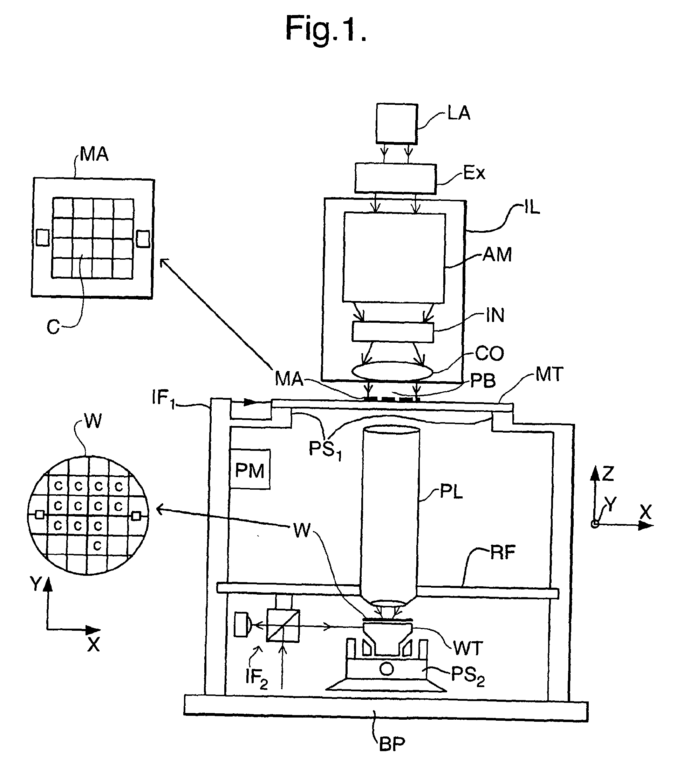

Figure 1 schematically depicts a lithographic projection apparatus according to the invention. The apparatus comprises:

- a radiation system LA, IL for supplying a projection beam PB of radiation (*e.g.* UV or EUV radiation, x-rays, electrons or ions);
- a first object table (mask table) MT provided with a mask holder for holding a mask MA (*e.g.* a reticle), and connected to first drive means PS1 for accurately moving the mask with respect to item PL;
- a second object table (substrate table) WT provided with a substrate holder for holding a substrate W (*e.g.* a resist-coated silicon wafer), and connected to second drive means PS2 for accurately moving the substrate with respect to item PL;
- a projection system ("lens") PL (*e.g.* a refractive or catadioptric system, a mirror group or an array of field deflectors) for imaging an irradiated portion of the mask MA onto a target portion C of the substrate W.

As here depicted, the apparatus is of a transmissive type (*i.e.* has a transmissive mask). However, in general, it may also be of a reflective type, for example.

The radiation system comprises a source LA (*e.g.* a Hg lamp, excimer laser, a discharge plasma source, a laser-produced plasma source, an undulator provided around the path of an electron beam in a storage ring or synchrotron, or an electron or ion beam source) which produces a beam of radiation. This beam is passed along various optical components comprised in the illumination system IL, — *e.g.* beam shaping optics Ex, an integrator IN and a condenser CO — so that the resultant beam PB has a desired form and intensity distribution.

The beam PB subsequently intercepts the mask MA which is held in a mask holder on a mask table MT. Having passed through the mask MA, the beam PB passes through the lens PL, which focuses the beam PB onto a target portion C of the substrate W. With the aid of the measuring system IF2 and the second drive means PS2, the substrate table WT can be moved accurately, *e.g.* so as to position different target portions C in the path of the beam PB. Similarly, the first drive means PS1 can be used to accurately position the mask MA with respect to the path of the beam PB, *e.g.* after mechanical retrieval of the mask MA from a mask library. In general, movement of the object tables MT, WT can be realized with the aid of a long-stroke module (coarse positioning) and a short-stroke module (fine positioning), which are not explicitly depicted in Figure 1.

The depicted apparatus can be used in two different modes:

> 1. In step mode, the mask table MT is kept essentially stationary, and an entire mask image is projected in one go (*i.e.* a single "flash") onto a target portion C. The substrate table WT is then shifted in the X and/or Y directions so that a different target portion C can be irradiated by the beam PB;
> 2. In scan mode, essentially the same scenario applies, except that a given target portion C is not exposed in a single "flash". Instead, the mask table MT is movable in a given direction (the so-called "scan direction", *e.g.* the Y-direction) with a speed v, so that the projection beam PB is caused to scan over a mask image; concurrently, the substrate table WT is simultaneously moved in the same or opposite direction at a speed $V = Mv$, in which $M$ is the magnification of the lens PL (typically, $M = 1/4$ or $1/5$). In this manner, a relatively large target portion C can be exposed, without having to compromise on resolution.

The apparatus also includes a base frame BP (also referred to as a base plate or machine frame) to support the components of the apparatus to support the projection system PL and sensors such as the measuring system.

As here depicted both tables will be movable and the measuring system comprising the interferometers IF1 and IF2 will measure the position of the first and second object table. The signal generated with the interferometer IF1 may be used to generate a force adjustment signal for the drive means PS 1 and the signal generated with interferometer IF2 may be used to generate a force adjustment signal for the drive means PS2. The processing means PM comprises a data storage means for generating a force adjustment signal for adjusting the force FO exerted by the drive means PS1 (or PS2) on its respective object table in response to a measurement signal from the measuring system IF1 (or IF2). The disturbance compensation force stored in the data storage means may be an array of forces FO to be exerted in the X, Y and Rz (rotational movement in the plane X, Y) direction as a function of a position measurement in the Y-direction, which is the scanning direction of the apparatus. Additionally one could also store forces FO to be exerted in the Rx, Ry and Z direction as a function of the Y position and yet further one could also store these forces FO as a function of the X, Y and Z position (and possibly also as a function of the Rx, Ry and Rz.

Storing the forces as a function of the X and Y position may be advantageously in a planar motor according to WO 01/18944. In a planar motor not forming part or the invention the second object table will be moved over a long range in the X and Y direction over a plate of magnets. For high precision positioning one might use a two step positioning system in which the planar motor functions as a long stroke motor and an additional Lorentz motor functions as a short stroke motor. The feedforward signal will then be used to compensate for any disturbance of the short-stroke motor caused by the plate of magnets present in the planar motor.

Figure 3 shows a detailed flow chart of a first embodiment of the invention. The required object table position is generated by a set point generator 31 and is fed to an object table controller 33. The object table controller 33 calculates a force 39 to be exerted on the object table 43. The position of the object table and therefore the influence of the set point generator will be measured with the position measurement system 41. The set point of the set point generator 31 will be fed to a processor means 37 via connection 47. This set point will be used in the data storage means 35 to obtain a disturbance compensation force that is being transformed in a force adjustment signal 49 in the processor means 37 and will be added to the total force 39. Line 45 gives an alternative for connection 47. If it is required that the disturbance compensation force is not dependent on the set point generator 31 it is better to use the connection 45 and use the real measurement data to process the force adjustment signal 49.

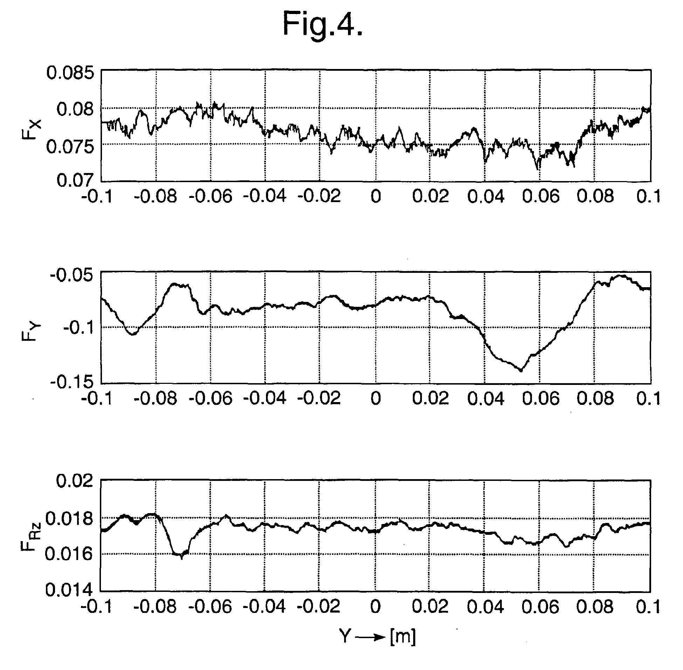

Figure 4 shows the result of moving the first object table in the scanning Y-direction and simultaneously measuring the external magnetic forces exerted on the first object table. These measurements are obtained by moving the first object table with a relatively low speed of 0.025 meter per second in the Y-direction and simultaneously measuring the force exerted by the drive means to keep the first object table moving with a constant speed in the Y-direction. The constant speed is controlled with a measurement means and any deviation of the constant speed leads to an adjusted force exerted by the drive means. This adjusted force is shown in Figure 4. The measurement means is also used to control the position of the object table in other degrees of freedom (X and Y) and any deviation from that position also leads to an adjusted force output by the drive means, which is also shown in figure 4. A low speed ensures that the difference between the required and the actual position is minimal and hence the force exerted by the drive means is an accurate measure of the disturbance force. As can be seen in the Y-direction around -0.08 and 0.05 strong deviations from a straight line can be observed. The disturbance correction forces as depicted in figure 4 can be obtained several times averaged and then filtered to enhance the disturbance correction forces in the data storage means as a function of the position in the Y-direction.

Embodiment 2

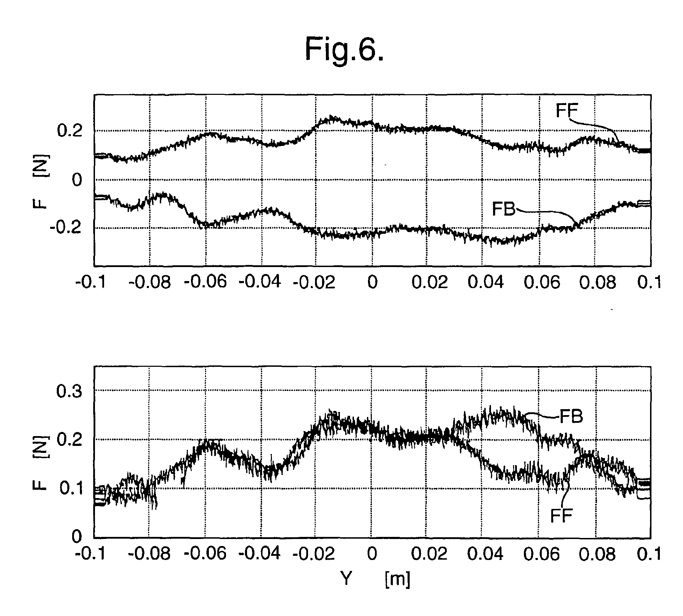

The magnetic disturbance forces exerted by on an object table may show besides a position dependency also a speed dependency. Therefore it may be necessary to calculate a velocity from the signals produced by the measuring system IF or the set point generator to calculate a force adjustment signal as a function of the disturbance correction force and the speed of said one object table. Figure 5 shows a detailed flow chart of a second embodiment according to the invention. It shares most items with the first embodiment according to the invention. An extra set point, representing the speed of said one object table is generated by the set point generator 31 which is fed via the connection 51 to the processor means 37 that also comprises a calculating means for calculating a force adjustment signal as a function of the position and the velocity of the object table. The calculating means may just simply multiply the disturbance compensation force with the velocity of the object table.

Figure 6 shows the velocity dependent magnetic disturbance forces in the Y- direction of the first object table moving in the Y-direction. These measurements are obtained by moving the first object table with a relatively high speed of 1 meter per second in the Y-direction and simultaneously measuring the force exerted by the drive means to keep the first object table moving with a constant speed in said first direction. The constant speed is controlled with the measuring system, for example IF1 (and IF2) in figure 1 or 41 in figure 3 and 5. The force exerted by the drive means to keep the first object table moving with a constant speed is stored in the data storage means as a function of the position in the Y-direction. Further, the force exerted by the drive means to keep the first object table in a constant position in the other degrees of freedom is also checked by the measuring means and the force exerted will be stored in data storage means as a function of the position in said first degree of freedom.

In the graph on top of figure 6 the line FF shows the forces when the first object table is moved forward in the Y-direction and the line FB the forces when the first object table is moved backward in the Y-direction. In the bottom graph the line FB of the top graph is multiplied by -1 and plotted in the same graph as line FF. lines FF and FB show a nearly perfect match except for the region of + 0.05 meter. This coincides with the region where the position dependent external magnetic forces are non zero in the graph of the Y-forces of figure 4. The fact that the force measurements have an opposite sign for opposite movement directions shows that the disturbance forces are largely velocity dependent. The forces as depicted in figure 6 can be filtered to get a disturbance force compensation table comprising forces to be exerted to compensate for the velocity and position dependent external magnetic disturbance forces as a function of the position in the Y-direction. The values in the table should be multiplied with the velocity of the first object table to get the adjustment force FO or 49. Table 1 shows the moving average MA and the moving standard deviation MSD values in nanometers for the X- and Y- direction and in nanoradians for Rz for the first object table.

Table 1

|  | MA-X [nm] | MA-Y [nm] | MA-Rz [nrad] | MSD-X [nm] | MSD-Y [nm] | MSD-Rz [nrad] |
|---|---|---|---|---|---|---|
| No disturbance force compensation | 2.27 | 4.57 | 12.92 | 11.64 | 10.57 | 42.29 |
| Position-dependent force compensation | 2.28 | 4.35 | 11.83 | 11.68 | 10.11 | 42.08 |
| Velocity-dependent force compensation | 1.77 | 2.66 | 8.57 | 11.37 | 9.43 | 37.24 |
| Position and Velocity-dependent force compensation | 1.78 | 1.44 | 5.96 | 11.41 | 9.15 | 36.03 |

The table shows that both the MA and the MSD values are improved by applying the disturbance compensation forces according to the invention. For a correct understanding it is important to keep in mind that the velocity dependent force correction is in fact dependent on position and velocity.

Whilst specific embodiments of the invention have been described above, it will be appreciated that the invention may be practiced otherwise than as described. The description is not intended to limit the invention which is defined by the claims.

**Claims**

1.   A lithographic projection apparatus comprising:

   a radiation system (IL) for providing a projection beam (PB) of radiation;
   a first object table (MT) for holding patterning means (MA) capable of patterning the projection beam (PB) according to a desired pattern;
   a second object table (WT) for holding a substrate (W); and
   a projection system (PL) for imaging the patterned beam onto a target portion of the substrate (W);
   drive means (PS1, PS2) for generating a force so as to move one of the first and second object tables in at least a first direction during an imaging operation;

data storage means (35) for storing data relating to disturbance forces experienced by said one object table (MT,WT) as a function of its position relative to said projection system (PL); and

processor means (37), responsive to a signal representing the position of said one object table (MT,WT) arranged to read data relating to said disturbance forces from said data storage means and to control said drive means (PS1, PS2) on the basis of said data to apply an adjustment force to said one object table (MT,WT) in a plane perpendicular to the optical axis of said projection system (PL) to compensate for said disturbance forces; **characterised in that**:

said drive means (PS1, PS2) comprises a short-stroke motor and a long-stroke motor for moving said one object table (MT,WT) and the short-stroke motor is arranged to exert said adjustment force.

2. An apparatus according to claim 1, wherein said apparatus further comprises a measuring system (IF) arranged to measure the position of said one object table (MT,WT) and to generate the signal representing the position of said one object table (MT,WT)

3. Apparatus according to claim 1, wherein said apparatus further comprises a control system (31, 35) arranged to control the movement of the object tables (MT,WT) and to generate the signal representing the position of said one object table (MT,WT)

4. Apparatus according to claim 1, 2 or 3, wherein said processor means (37) comprises calculating means arranged to determine the adjustment force as a function of said data read from said data storage means (35) and the velocity of said one object table (MT,WT).

5. Apparatus according to claim 4, wherein said function is a multiplication of the data read from said data storage means (35) with the velocity of said one object table (MT,WT).

6. Apparatus according to any one of the preceding claims, wherein the processor means (37) is arranged to read out two data in response to a signal representing the position of said one object table (MT,WT):

a first datum for directly generating a first adjustment force component in response to said first datum, and a second datum for generating a second adjustment force component as a function of said second datum and the velocity of said one object table; wherein said adjustment force is a combination of said first and second force adjustment components.

7. Apparatus according to any one of claims 1 to 5, wherein the drive means (PS1, PS2) is arranged to move said one object table (MT,WT) in at least two degrees of freedom and the processor means (37) reads at least two data in response to a signal representing the position of said one object table (MT,WT) said at least two data being used for generating an adjustment force in said at least two degrees of freedom.

8. Apparatus according to any one of claims 1 to 5, wherein the drive means (PS1, PS2) is arranged to move said one object table (MT,WT) in at least two degrees of freedom and said processor means (37) is arranged to read out a datum in response to a signal representing the position of said one object table in at least two degrees of freedom.

9. Apparatus according to any one of claims 1 to 3 wherein said data storage means (35) is arranged to store data relating to disturbance forces as a function of both the position of said one object table (MT,WT) and its velocity and data is read out therefrom in response to signals representing both the position and velocity of said one object table.

10. Apparatus according to any of the preceding claims, wherein the radiation system (IL) comprises a radiation source (LA).

11. Apparatus according to any of the preceding claims, wherein the patterning means is a mask (MA) and the first object table is a mask table (MT) for holding the mask.

12. A device manufacturing method comprising the steps of:

providing a substrate (W) that is at least partially covered by a layer of radiation sensitive material to a second object table (WT); providing a projection beam of radiation using a radiation system; using patterning means (MA) held by a first object table (MT) to endow the projection beam (PB) with a pattern in its cross-section;

moving both the object tables (MT,WT) with drive means (PS1,PS2) in a first direction whilst the patterning means is being used;

projecting the patterned beam of radiation onto a target portion of the layer of radiation-sensitive material with a projection system (PL);

reading data from data storage means (35) in response to a signal representing the position of one of the object tables (MT,WT) said data representing disturbance forces experienced by said one object table (MT,WT) as a function of its position;

determining an adjustment force in response to said data; and exerting said adjustment force by the drive means (PS1,PS2) on said one object table (MT,WT), said adjustment force being in a plane perpendicular to the optical axis of said projection system (PL), **characterised in that**:

said drive means (PS1, PS2) comprises a short-stroke motor and a long-stroke motor for moving said one object table and the adjustment force is exerted by the short-stroke motor.

## Patentansprüche

1. Lithographische Projektionsvorrichtung, mit:

einem Strahlungssystem (IL) zum Bereitstellen eines Projektionsstrahls (PB) aus Strahlung;

einem ersten Objekttisch (MT) zum Halten einer Musteraufbringungseinrichtung (MA), die den Projektionsstrahl (PB) gemäß einem gewünschten Muster mustert;

einem zweiten Objekttisch (WT) zum Halten eines Substrats (W); und

einem Projektionssystem (PL) zum Abbilden des gemusterten Strahls auf einen Zielabschnitt des Substrats (W);

Antriebseinrichtungen (PS1, PS2) zum Erzeugen einer Kraft, um einen des ersten und zweiten Objekttisches während eines Abbildungsvorgangs in wenigstens eine erste Richtung zu bewegen;

einer Datenspeichereinrichtung (35) zum Speichern von Daten, die sich auf Verteilungskräfte beziehen, denen der besagte eine Objekttisch (MT, WT) als eine Funktion seiner Position in Bezug auf das Projektionssystem (PL) ausgesetzt war; und

einer Prozessoreinrichtung (37), die auf ein Signal reagiert, das die Position des besagten einen Objekttisches (MT, WT) repräsentiert und Daten, die sich auf besagte Verteilungskräfte beziehen, aus der besagten Speichereinrichtung ausliest und besagte Antriebseinrichtungen (PS1, PS2) auf der Basis der besagten Daten steuert, um eine Einstellkraft auf den besagten einen Objekttisch (MT, WT) in einer Ebene anlegen zu können, die sich senkrecht zur optischen Achse des besagten Projektionssystems (PL) befindet, um die besagten Verteilungskräfte zu kompensieren;

**dadurch gekennzeichnet, dass**:

die besagten Antriebseinrichtungen (PS1, PS2) einen Kurzhubmotor und einen Langhubmotor umfassen, um den besagten einen Objekttisch (WT, MT) bewegen zu können, und dass der Kurzhubmotor die besagte Einstellkraft ausübt.

2. Vorrichtung nach Anspruch 1, wobei die Vorrichtung ferner ein Messsystem (IF) umfasst, das die Position des besagten einen Objekttisches (MT, WT) misst und das die Position des besagten einen Objekttisches (MT, WT) repräsentierende Signal erzeugt.

3. Vorrichtung nach Anspruch 1, wobei die Vorrichtung ferner ein Steuersystem (31, 35) umfasst, das die Bewegung des Objekttisches (MT, WT) steuert und das die Position des besagten einen Objekttisches (MT, WT) repräsentierende Signal erzeugt.

4. Vorrichtung nach Anspruch 1, 2 oder 3, wobei die Prozessoreinrichtung (37) Berechnungseinrichtungen umfasst, die die Einstellkraft als eine Funktion der aus der Datenspeichereinrichtung (35) gelesenen Daten und die Geschwindigkeit des einen besagten Objekttisches (MT, WT) bestimmt.

5. Vorrichtung nach Anspruch 4, wobei die besagte Funktion eine Multiplikation der aus der Datenspeichereinrichtung (35) gelesenen Daten mit der Geschwindigkeit des besagten einen Objekttisches (MT, WT) ist.

6. Vorrichtung nach jedem der vorhergehenden Ansprüche, wobei die Prozessoreinrichtung (37) zwei Datenwerte als Antwort auf ein Signal ausliest, das die Position des besagten einen Objekttisches (MT, WT) repräsentiert:

einen ersten Wert zur direkten Erzeugung einer ersten Einstellkraftkomponente als Antwort auf den besagten ersten Wert;

einen zweiten Wert zur Erzeugung einer zweiten Einstellkraftkomponente als eine Funktion des besagten zweiten Werts und der Geschwindigkeit des besagten einen Objekttisches;

wobei die besagte Einstellkraft eine Kombination aus den besagten ersten und zweiten Krafteinstellkomponenten ist.

7. Vorrichtung nach jedem der Ansprüche 1 bis 5, wobei die Antriebseinrichtungen (PS1, PS2) den besagten einen Objekttisch (MT, WT) in wenigsten zwei Freiheitsgraden bewegen und die Prozessoreinrichtung (37) wenigstens zwei Datenwerte als Antwort auf ein Signal ausliest, das die Position des besagen einen Objekttisches (MT, WT) repräsentiert, wobei die besagten wenigstens zwei Datenwerte zum Erzeugen einer Einstellkraft in den besagten wenigstens zwei Freiheitsgraden verwendet werden.

8. Vorrichtung nach jedem der Ansprüche 1 bis 5, wobei die Antriebseinrichtungen (PS1, PS2) den besagten einen Objekttisch (MT, WT) in wenigstens zwei Freiheitsgraden bewegen und die Prozessoreinrichtung (37) einen Wert als Antwort auf ein Signal ausliest, das die Position des besagten einen Objekttisches in wenigstens zwei Freiheitsgraden repräsentiert.

9. Vorrichtung nach jedem der Ansprüche 1 bis 3, wobei die Datenspeichereinrichtung (35) Daten speichert, die sich auf Störkräfte als eine Funktion von sowohl der Position des besagten einen Objekttisches (MT, WT) als auch seiner Geschwindigkeit beziehen, und Daten daraus ausgelesen werden als Antwort auf Signale, die sowohl die Position als auch die Geschwindigkeit des besagten einen Objekttisches repräsentierten.

10. Vorrichtung nach jedem der vorhergehenden Ansprüche, wobei das Strahlungssystem (IL) eine Strahlungsquelle (LA) umfasst.

11. Vorrichtung nach jedem der vorhergehenden Ansprüche, wobei die Musteraufbringungseinrichtung eine Maske (MA) und der erste Objekttisch ein Maskentisch (MT) zum Halten der Maske ist.

12. Verfahren zur Herstellung eines Bauteils, das folgende Schritte umfasst: Bereitstellen eines Substrats (W), das zumindest teilweise von einer Schicht aus strahlungsempfindlichem Material bedeckt ist, für einen zweiten Objekttisch (WT);
Bereitstellen eines Projektionsstrahls aus Strahlung unter Verwendung eines Strahlungssystems; unter Verwendung einer Musteraufbringungseinrichtung (MA), die von einem ersten Objekttisch (MT) gehalten wird, um den Projektionsstrahl (PB) in seinem Querschnitt mit einem Muster zu versehen; Bewegen von beiden Objekttischen (MT, WT) mittels Antriebseinrichtungen (PS1, PS2) in eine erste Richtung, während die Musteraufbringungseinrichtung im Einsatz ist; Projizieren des gemusterten Strahls aus Strahlung auf einen Zielabschnitt der Schicht aus strahlungsempfindlichem Material mittels eines Projektionssystems (PL);Auslesen von Daten aus einer Datenspeichereinrichtung (35) als Antwort auf ein Signal, das die Position einer der Objekttische (MT, WT) repräsentiert, wobei die besagten Daten Störkräfte repräsentieren, denen der besagte eine Objekttisch (MT, WT) als eine Funktion seiner Position ausgesetzt worden ist;Bestimmen einer Einstellkraft als Antwort auf die besagten Daten; und Ausüben der besagten Einstellkraft durch die Antriebseinrichtungen (PS1, S2) auf den besagten einen Objekttisch (MT, WT), wobei sich die besagte Einstellkraft in einer Ebene befindet, die sich senkrecht zur optischen Achse des besagten Projektionssystems (PL) befindet, **dadurch gekennzeichnet, dass**:

die besagten Antriebseinrichtungen (PS1, PS2) einen Kurzhubmotor und einen Langhubmotor zum Bewegen des besagten einen Objekttisches umfassen und die Einstellkraft durch den Kurzhubmotor ausgeübt wird.

**Revendications**

1. Appareil de projection lithographique comprenant :

un système de rayonnement (IL) pour délivrer un faisceau de projection (PB) de rayonnement ;
une première table d'objet (MT) pour supporter des moyens de mise en forme (MA) capables de mettre en forme le faisceau de projection (PB) conformément à un motif voulu ;

une seconde table d'objet (WT) pour supporter un substrat (W) ; et

un système de projection (PL) pour représenter le faisceau mis en forme sur une partie cible du substrat (W) ;

des moyens d'entraînement (PS1, PS2) pour générer une force de manière à déplacer une des première et seconde tables d'objet dans au moins une première direction pendant une opération d'imagerie ;

des moyens de stockage de données (35) pour mémoriser des données concernant des forces de perturbation rencontrées par ladite une table d'objet (MT, WT) en fonction de sa position par rapport audit système de projection (PL) ; et

des moyens de processeur (37) sensibles à un signal représentant la position de ladite une table d'objet (MT, WT), conçus pour lire des données concernant lesdites forces de perturbation dans lesdits moyens de stockage de données et pour commander lesdits moyens d'entraînement (PS1, PS2) sur la base desdites données pour appliquer une force d'ajustement à ladite une table d'objet (MT, WT) dans un plan perpendiculaire à l'axe optique dudit système de projection (PL) pour compenser lesdites forces de perturbation ;

**caractérisé en ce que** :

lesdits moyens d'entraînement (PS1, PS2) comprennent un moteur à course courte et un moteur à course longue pour déplacer ladite une table d'objet (MT, WT) et le moteur à course courte est conçu pour exercer ladite force d'ajustement.

2. Appareil selon la revendication 1, dans lequel ledit appareil comprend de plus un système de mesure (IF) conçu pour mesurer la position de ladite une table d'objet (MT, WT) et pour générer le signal représentant la position de ladite une table d'objet (MT, WT).

3. Appareil selon la revendication 1, dans lequel ledit appareil comprend de plus un système de commande (31, 35) conçu pour commander le déplacement des tables d'objet (MT, WT) et pour générer le signal représentant la position de ladite une table d'objet (MT, WT)

4. Appareil selon la revendication 1, 2 ou 3, dans lequel lesdits moyens processeurs (37) comprennent des moyens de calcul conçus pour déterminer la force d'ajustement en fonction desdites données lues dans lesdits moyens de stockage de données (35) et de la vitesse de ladite une table d'objet (MT, WT).

5. Appareil selon la revendication 4, dans lequel ladite fonction est une multiplication des données lues dans lesdits moyens de stockage de données (35) par la vitesse de ladite une table d'objet (MT, WT).

6. Appareil selon l'une quelconque des revendications précédentes, dans lequel les moyens de processeur (37) sont conçus pour lire deux données en réponse à un signal représentant la position de ladite une table d'objet (MT, WT) :

une première donnée pour générer directement une première composante de force d'ajustement en réponse à ladite première donnée, et

une seconde donnée pour générer une seconde composante de force d'ajustement en fonction de ladite seconde donnée et de la vitesse de ladite une table d'objet ;

dans lequel ladite force d'ajustement est une combinaison desdites première et seconde composantes de force d'ajustement.

7. Appareil selon l'une quelconque des revendications 1 à 5, dans lequel les moyens d'entraînement (PS1, PS2) sont conçus pour déplacer ladite une table d'objet (MT, WT) selon au moins deux degrés de liberté et les moyens de processeur (37) lisent au moins deux données en réponse à un signal représentant la position de ladite une table d'objet (MT, WT), lesdites au moins deux données étant utilisées pour générer une force d'ajustement selon lesdits au moins deux degrés de liberté.

8. Appareil selon l'une quelconque des revendications 1 à 5, dans lequel les moyens d'entraînement (PS1, PS2) sont conçus pour déplacer ladite une table d'objet (MT, WT) selon au moins deux degrés de liberté et lesdits moyens de processeur (37) sont conçus pour lire une donnée en réponse à un signal représentant la position de ladite une table d'objet selon au moins deux degrés de liberté.

9. Appareil selon l'une quelconque des revendications 1 à 3, dans lequel lesdits moyens de stockage de données (35) sont conçus pour mémoriser des données concernant des forces de perturbation en fonction à la fois de la position de ladite une table d'objet (MT, WT) et de sa vitesse et des données sont lues à partir de ceux-ci en réponse à des signaux représentant à la fois la position et la vitesse de ladite une table d'objet.

**10.** Appareil selon l'une quelconque des revendications précédentes, dans lequel le système de rayonnement (IL) comprend une source de rayonnement (LA).

**11.** Appareil selon l'une quelconque des revendications précédentes, dans lequel les moyens de mise en forme sont un masque (MA) et la première table d'objet est une table de masque (MT) pour supporter le masque.

**12.** Procédé de fabrication de dispositif comprenant les étapes consistant à :

agencer un substrat (W) qui est au moins partiellement recouvert d'une couche de matériau sensible au rayonnement sur une seconde table d'objet (WT) ;
délivrer un faisceau de projection de rayonnement en utilisant un système de rayonnement ; utiliser des moyens de mise en forme (MA) supportés par une première table d'objet (MT) pour doter le faisceau de projection (PB) d'un motif dans sa section transversale ;
déplacer les deux tables d'objet (MT, WT) à l'aide de moyens d'entraînement (PS1, PS2) dans une première direction alors que les moyens de mise en forme sont utilisés ;
projeter le faisceau de rayonnement mis en forme sur une partie cible de la couche de matériau sensible au rayonnement à l'aide d'un système de projection (PL) ;
lire des données dans des moyens de stockage de données (35) en réponse à un signal représentant la position d'une des tables d'objet (MT, WT), lesdites données représentant des forces de perturbation rencontrées par ladite une table d'objet (MT, WT) en fonction de sa position ;
déterminer une force d'ajustement en réponse auxdites données ; et
exercer ladite force d'ajustement par les moyens d'entraînement (PS1, PS2) sur ladite une table d'objet (MT, WT), ladite force d'ajustement se trouvant dans un plan perpendiculaire à l'axe optique dudit système de projection (PL), **caractérisé en ce que** :

lesdits moyens d'entraînement (PS1, PS2) comprennent un moteur à course courte et un moteur à course longue pour déplacer ladite une table d'objet et la force d'ajustement est exercée par le moteur à course courte.

# Fig.1.

# Fig.2.

# Fig.3.

# Fig.5.

# Fig.4.

# Fig.6.